# EUROPEAN PATENT APPLICATION

(11) **EP 1 098 354 A2**
(43) Date of publication of application: **09.05.2001**
(21) Application number: 00309920.7
(22) Date of filing: 08.11.2000
(51) Int. Cl.: H01L 21/00

(54) **Apparatus for controlling temperature in a semiconductor processing system**

(30) Priority: 08.11.1999 US 164159 P
(71) Applicant: Applied Materials, Inc., Santa Clara, CA 95054 (US)
(72) Inventor: Parkhe, Vijay, San Jose, CA 95135 (US)
(74) Representative: Draper, Martyn John

(57) **Abstract**

Apparatus for controlling temperature in a semiconductor processing system. The apparatus comprises a pedestal base (106), an electrostatic chuck (105) disposed above the pedestal base thereby defining an enclosure, a cooling plate (206) disposed within said enclosure and a plurality of Peltier effect thermoelectric devices (204) arranged on said cooling plate and in contact with said electrostatic chuck. The apparatus electrostatic chuck can be in a monopolar, bipolar or zonal configuration. The electrostatic chuck has one or more heater electrodes (160) and an RF biasable electrode (162).

## Description

Generally, the present invention relates to heat transfer in semiconductor processing systems. More specifically, the present invention relates to the application of thermoelectric devices for heating and cooling various components, structures or surfaces in a semiconductor processing system.

A substrate processing system generally comprises a plurality of process chambers for forming Very Large Scale Integrated Circuitry (VLSI) devices on a substrate such as a silicon wafer. The chambers have differing requirements for heating and/or cooling certain components or structures. That is, individual components or structures within or attached to a process chamber reach an undesirable temperature under a variety of conditions, causing improper processing on substrates. Generally, because the temperature of the substrate affects the processing results on the substrate, it is important to maintain the temperature of the substrate within a desirable range for proper processing. Particularly, in an ion metal plasma (IMP) chamber where a process gas, such as argon and ionized metal flux bombards the substrate and generates heat on the substrate, the temperature increase of the substrate must be controlled because the substrate has a thermal budget that must not be exceeded. If the thermal budget of the substrate is exceeded, improper processing results on the substrate, and device failure occurs.

An example of a component of a process chamber having both a cooling and a heating requirement is an electrostatic chuck (E-chuck) for retaining a substrate during processing. Usually, the E-chuck physically contacts the substrate and the temperature of the substrate is affected by the temperature of the E-chuck. Thus, for the aforementioned reasons, it is important to control the temperature of the E-chuck. For example, physical vapor deposition (PVD) of materials such as copper, aluminum, titanium, and tantalum is usually conducted at temperatures above 200 C for optimal film quality and coverage. The semiconductor industry is now shifting towards the use of copper as a deposited film. As such, much lower operational substrate temperatures (on the order of 50 C) are necessary to create a copper film of acceptable quality.

In an attempt to control the temperature of the E-chuck, a fluid (such as water or a low temperature coolant) is flowed through a small chamber or channel in or under the E-chuck. The fluid is heated or cooled in a remote heat exchanger unit disposed externally and remotely from the process chamber. The same fluid may heat or cool the E-chuck depending on the temperature of the fluid released by the heat exchanger unit. However, this temperature management technique responds slowly to temperature changes at the E-chuck because the temperature of the fluid is measured at the heat exchanger and the corrective actions take place at the heat exchanger, remotely from the E-chuck. Additionally, there are environmental concerns with the use of low temperature coolants in place of ordinary water.

Other attempts to control the temperatures of the components of a processing system use remote thermal electric heat exchangers. A thermoelectric (TE) device transfers heat according to the Peltier effect. When a current is passed through a junction of two dissimilar conductors, the Peltier effect causes a temperature change that is proportional to the current through the junction. One end of the conductor becomes cold while the other end of the conductor becomes hot. This well-known principle can produce temperature differentials of up to 100 F and can cool the cold end of the conductor even below the freezing point of water. One example of a TE device is the DuraTEC available from Marlow Industries, Inc., Dallas, Texas. A TE device may be used with a fluid to flow heat to or from a remote object, so the TE device can heat or cool the object remotely, as in a heat exchanger. Examples of such uses are described in the following United States Patents.

United States Patent 5,613,364 describes a temperature control module for heating or cooling part or all of the interior of a process module. The temperature control module is mounted on the exterior of the process module and has a thermoelectric heat exchanger assembly, remote from the internal space of the process module, using a dielectric liquid that flows in and out of the process module to cool or heat the inside of the process module. The temperature control module also has a temperature sensor for sensing the temperature of the dielectric liquid as the liquid flows into the temperature control module, thereby indicating the temperature in the process module.

United States Patent 5,154,661 describes a thermal electric cooling system for cooling a wafer chuck or a developer cooling tank. The thermal electric cooling system is located remotely from the wafer chuck or the developer cooling tank. The thermal electric cooling system includes a cooling reservoir for cooling a coolant fluid that circulates to the wafer chuck or developer cooling tank. A temperature sensor is located in the cooling reservoir for providing feedback regarding the temperature of the coolant fluid, so that a controller can adjust an array of thermal electric cooler cells to maintain the coolant fluid at a particular temperature.

United States Patent 5,029,445 describes a thermal electric cooling system for maintaining a predetermined liquid temperature in a liquid bath in a wet process station for processing semiconductor wafers. The thermal electric cooling system is located remotely from the liquid bath and the wet process station. The thermal electric cooling system has an inlet and an outlet for circulating cooled liquid to the wet process station. The thermal electric cooling system also has a heater for heating the liquid after it has been cooled by the thermal electric cooler to raise the liquid temperature to a desired level. The temperature of the heater is sensed by a thermistor to provide temperature feedback to a controller.

United States Patent 5,450,726 describes a thermal electric air cooling apparatus for use with climate or environmental control systems in the semiconductor and other industries. As in the previously described cooling systems, the thermal electric air cooling apparatus is located remotely from the structure or space which it cools. An inlet and an outlet permit the air to circulate to and from the thermal electric air cooling apparatus. A heater may heat the air, so that the combined performance of the heater and the cooling apparatus can maintain the temperature of the air at a desired temperature. A thermocouple detects the temperature of the air at the outlet from the thermal electric air cooling apparatus to provide temperature feedback to a controller.

However, the applications for TE devices described above are inefficient for heating or cooling structures within a semiconductor processing system because they are located remotely from the part being heated and/or cooled. Considerable heat loss or gain may occur between the heat exchanger and the structure, resulting in a less than optimum usage of the TE device's heat transfer capability. Additionally, since the TE device is disposed remotely from the structure, there is a built-in delay in the response time of the TE device to the changes in temperature at the component of the processing system. Furthermore, a coolant fluid flowing from a remote heat exchanger into the processing system and around or near the structure to exchange heat with the structure exhibits a temperature variation or gradient along its flow path, so the structure is not cooled or heated uniformly.

Therefore, a need exists for a processing system that provides a more exacting control and a faster response to temperature variations in particular components of the processing system. It would be desirable if the processing system has a better heat transfer capacity at the heated component to allow immediate correction to temperature variations.

The disadvantages of the prior art are overcome by the present invention of an apparatus for controlling temperature in a semiconductor processing system. The apparatus comprises a pedestal base, a substrate support disposed above the pedestal base thereby defining an enclosure, a cooling plate disposed wichin said enclosure and a plurality of Peltier effect thermoelectric devices arranged on said cooling plate and in contact with said substrate support. The substrate support can be an electrostatic chuck of monopolar, bipolar or zonal configuration. The electrostatic chuck has one or more heater electrodes and an RF biasable electrode above a plane defined by the thermoelectric devices.

The teachings of the present invention can be readily understood by considering the following detailed description in conjunction with the accompanying drawings, in which:
FIG. 1 depicts a partial schematic, partial cross-sectional view of a semiconductor process chamber employing the subject invention;
FIG. 2 depicts a detailed cross-sectional view of a substrate support containing the subject invention;
FIG. 3 depicts a schematic view of a semiconductor process system employing the subject invention;
FIG. 4 depicts detailed view of a preferred embodiment of the subject invention; and
FIG. 5 depicts an alternate embodiment of temperature control device of the subject invention.

To facilitate understanding, identical reference numerals have been used, where possible, to designate identical elements that are common to the figures.

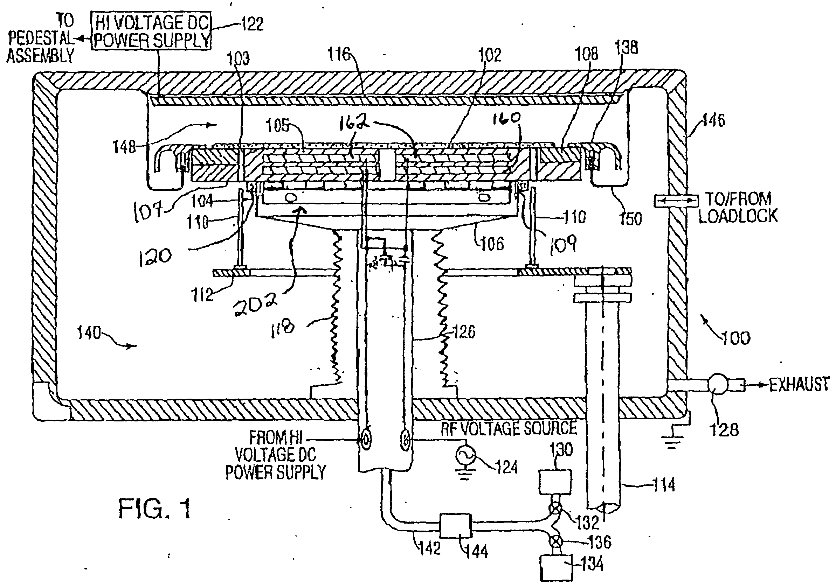

FIG. 1 depicts a cross-sectional view of a PVD processing chamber 100 for processing a workpiece 102, i.e., a semiconductor wafer undergoing metal deposition in a workpiece processing system. For a detailed understanding of the PVD processing chamber 100 and its operation in processing a wafer, the reader should refer to the drawings and the detailed description contained in commonly assigned U.S. Patent No. 5,228,501, issued July 20, 1993 incorporated herein by reference. That disclosure discloses a wafer support assembly used in a physical vapor deposition chamber manufactured by Applied Materials, Inc. of Santa Clara, California.

The wafer 102 is disposed on an apparatus 104 for retaining the wafer against a workpiece support, providing RF biasing to the wafer and controlling wafer temperature. Specifically, the pedestal assembly 104 has a puck 105, i.e., a substrate support, supported by a pedestal base 106 and a shaft 126. The shaft 126 provides access for wiring to conduct DC and RF power from remote power sources 122 and 124 to the pedestal assembly 104. The shaft 124 is sheathed in a bellows 118 to maintain environmental integrity between a vacuum inside the chamber 100 and ordinary atmosphere within the bellows 118 and shaft 126. The puck 105 is discussed as being a substrate support and in a preferred embodiment, is an electrostatic chuck. Alternately, the puck may be a heater used in a chemical vapor deposition (CVD) process system (i.e., having no electrostatic chucking capabilities) or any other type of general purpose workpiece support in a system requiring RF biasing of the workpiece. Additionally, the shaft 126 is provided with a gas conduit 142 to feed a gas through the pedestal assembly 104 to a process cavity 148 located directly above the pedestal assembly 104 and/or a backside of the wafer 102. The gas conduit 142 is connected to one or more gas sources 130, 134 via respective valves 132, 136 and a mass flow controller (MFC) 144. Lift pins 110 mounted on a platform 112 connected to a vertical shaft 114 serve to lift the wafer 102 off the support surface 103 after processing.

A target 116 of sputtering or deposition material is positioned over the pedestal assembly 104. The target 116 is selected from the group consisting of aluminum, titanium, copper and is preferably copper and is electrically insulated from the chamber 100. The first remote power source 122 is preferably a high voltage DC power supply and is electrically connected between the target 116 and ground for magnetron sputtering a wafer. Additionally, an RF (radio frequency) voltage source 124 is coupled to the pedestal assembly 104 as explained in greater detail below. A waste ring 108, a cover ring 138 and a shield 150 circumscribe the pedestal assembly 104 thereby defining the process cavity 148 and preventing unwanted deposition into a lower chamber region 140.

The pedestal base 106 is usually fabricated from a durable material, e.g., stainless steel or a similar metallic material. In a preferred embodiment of the invention, the pedestal base is stainless steel. Disposed atop the pedestal base 106 is a support ring 109. Specifically, support ring 109 is cylindrical in shape and is secured (via welding or a similar means) to the pedestal base 106. In a preferred embodiment, the support ring 109 is KOVAR^{®}. KOVAR^{®} is the tradename for an iron/nickel/cobalt alloy manufactured and sold by Westinghouse Electric Co. The wafer 102 rests on support surface 103 of the substrate support (e.g. an electrostatic chuck) 105. The electrostatic chuck 105 also has a bottom surface 107 and can be fabricated from a dielectric material e.g., a ceramic such as silicon oxide, silicon nitride, sapphire or the like and is shaped as a thin circular puck. The chuck 105 is attached to the support ring 109. A retaining ring 120 is provided around the support ring 109. The substrate support 105 support ring 109, and pedestal base 106 define an enclosure 152. An example of a ceramic electrostatic chuck that may be used in this apparatus is disclosed in commonly assigned U.S. Patent No. 5,656,093 issued August 12, 1997 to Burkhart and is incorporated by reference herein. Specifically, that reference discloses a ceramic electrostatic chuck having a wafer spacing mask of metallic material deposited on the chuck surface.

Within the body of the electrostatic chuck 105 are various conducting elements that assist in workpiece processing. For example, a heater electrode 160 may be buried within layers of the electrostatic chuck 105. The heater electrode 160 is fabricated from a conductive material, (e.g., tungsten) and is connected to one of the remote power sources 122 or 124. In this way, the heater electrode 160 generates heat which is transferred to the workpiece on top of the electrostatic chuck 105 to maintain the workpiece at proper processing temperatures. Additionally, the electrostatic chuck 105 may be provided with one or more chucking electrodes 162. The chucking electrodes 162 are also fabricated from a conductive material, (e.g., tungsten), but not necessarily the same material from which the heater electrode 160 is fabricated. The chucking electrodes 162 are disposed relatively closely to the top surface 103 of the electrostatic chuck 105. The chucking electrodes 162 are connected to a first remote power source, i.e. the high voltage DC power supply 122 of FIG. 1. In this way, the chucking electrodes 162 provide the necessary electrostatic force to the backside of a workpiece 102 to retain it on the electrostatic chuck 105. The chucking electrodes 162 may be in any configuration necessary to retain the workpiece upon the puck. For example, the chucking electrodes 162 may be in a monopolar configuration, bipolar configuration, zoned chucking configuration or the like. Additionally, the power source which energizes the chucking electrodes 162 may also be the power source for the heater electrode 160.

The chucking electrodes 162 are also connected to a second remote power source i.e., an RF power source 124. As such, RF power is capable of being coupled directly to the electrodes 162 (superimposed over the DC power) thereby biasing the wafer in a suitable manner for processing. A suitable electrostatic chuck having the necessary connections for both RF and DC power application to one set of electrodes is seen and described in U.S. Patent No. 5,886,866 issued March 23, 1999 to Hausmann and is herein incorporated by reference.

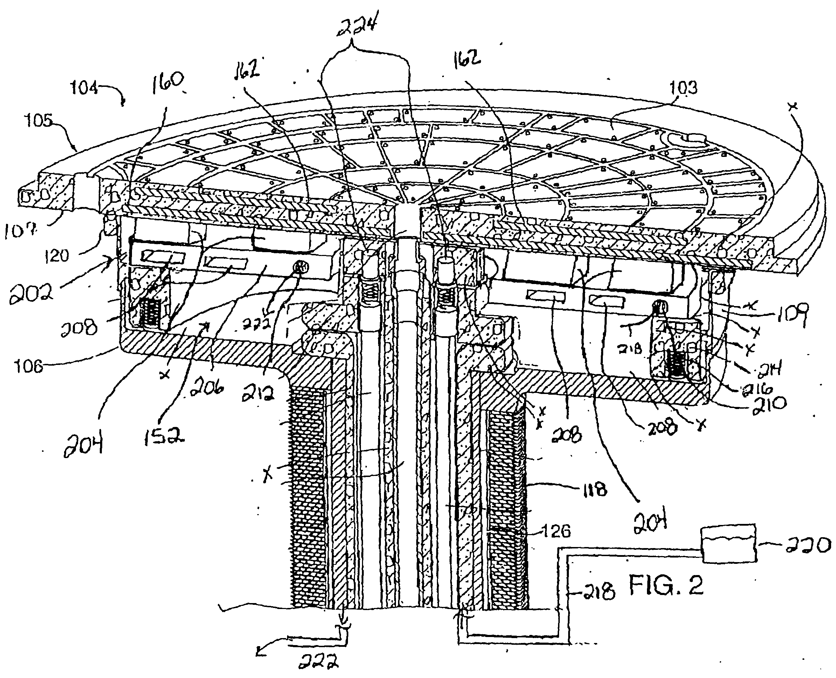

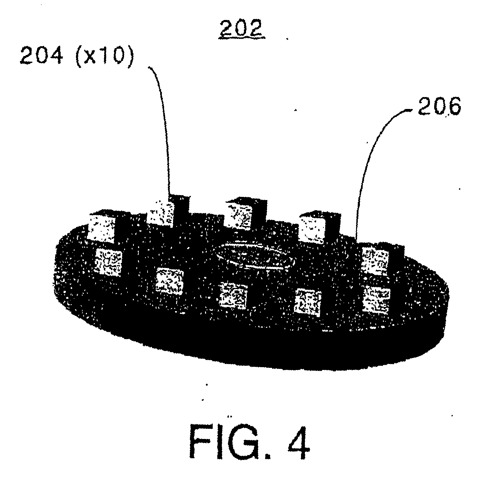

Disposed within the pedestal base 106, is a temperature control apparatus 202. The temperature control apparatus 202 exploits the benefits of the Peltier effect combined with liquid coolant to achieve the desired temperature control of the electrostatic chuck 105 and wafer 102 supported thereabove. FIG. 2 depicts a partial perspective, cross-sectional view of the pedestal assembly 104 so as to more clearly view the subject invention. Specifically, the temperature control apparatus 202 is comprised of a plurality of thermoelectric TE devices 204 and a cooling plate 206. The TE devices are capable of creating suitable thermal gradients to affect a temperature change in the electrostatic chuck 105. Such TE devices are commercially available from manufactures in this technology area and are preferably Bismuth/Telluride in composition though other types of materials are possible. In one embodiment of the invention, the TE devices 204 are arranged in a circular fashion on the cooling plate 206. Such an embodiment is more completely depicted in FIG. 4. In an alternate embodiment more particularly seen in FIG. 2, the TE devices 204 are concentrically arranged about the cooling plate 206. Such a concentric arrangement facilitates zonal temperature control (i.e., a plurality of inner TE devices define an inner temperature control zone and a plurality of outer TE devices define an outer temperature control zone. In a preferred embodiment of the invention, there are 40 TE devices 204 on the cooling plate 206 arranged in two concentric circles. It is within the spirit and scope of the invention to arrange the TE devices 204 upon the plate 206 in any manner or configuration for the desired heat transfer characteristic.

The TE devices 204 are approximately 1 cm on edge and attached to the bottom surface 107 of the electrostatic chuck 105 by a variety of means known to those skilled in the art of semiconductor process chamber fabrication. For example, in low temperature (below 200 C) applications, the TE devices 204 can be attached to the electrostatic chuck via a suitable adhesive. For high temperature applications (above 350 C) the TE devices 204 can be attached to the electrostatic chuck 105 via brazing. A third means is specifically depicted in FIG. 2 wherein the TE devices 204 are brazed to the cooling plate 206. The cooling plate 206 is then disposed upon a spring -loaded member 214. Specifically, the spring-loaded member 214 is a ring disposed in the pedestal base 106. The ring is provided with one or more springs 216 that bias the ring upwards. As such, the cooling plate 206 (with attached) TE devices 204 are also biased upwards and into intimate contact with the bottom surface 107 of the electrostatic chuck 105. In an additional alternate embodiment (not shown), the TE devices 204 can be integrated or set into the material (i.e., aluminum nitride) of which the electrostatic chuck 105 is made at some point during the chuck fabrication process. Again, the specifics of such integration process would be known to one skilled in the art.

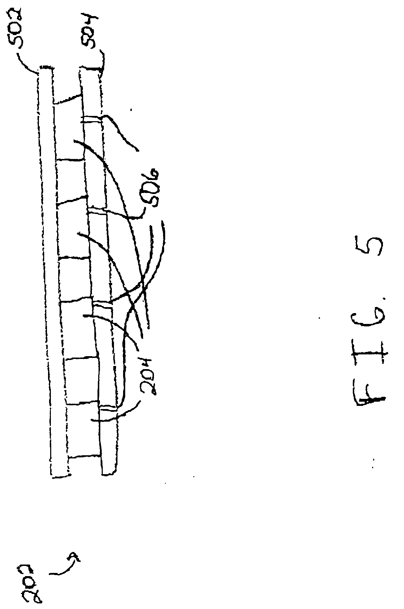

FIG. 5 depicts an alternate embodiment of the temperature control apparatus 202. Specifically, the temperature control apparatus 202 comprises a plurality of the TE devices 204 disposed between two plates of support material 502 and 504. The TE devices are bonded to an upper support plate 502 and a lower support plate 504 so as to create a permanent structure. The support plates 502 and 504 are thinner in dimension as compared co the TE devices 204 and are comprised of materials selected from the group consisting of aluminum nitride, metallic material and composites (i.e., AlSiMg, Aluminum-Silicon-Silicon-Carbide composite material and the like). The bonding is achieved by brazing the TE devices 204 to the support plates 502 and 504. The braze material is selected from the group consisting of aluminum alloys, gold/tin and gold/indium. When the brazing is done with electrically conductive materials (such as the aluminum alloys) electrical traces 506 are made to facilitate connection of the TE devices to a power source. In a preferred embodiment of the invention, the upper and lower support plate 502 and 504 are aluminum and the upper plate 502 is brazed to an electrostatic chuck (i.e., by brazing with AlMg alloy). In an alternate embodiment (not depicted) the upper support plate 502 is eliminated and the TE devices are bonded directly to the bottom of the substrate support 105. To complete installation of the temperature control apparatus 202 (regardless of the specific embodiment), it is bonded to the cooling plate 206. That is, the bottom support plate 504 is bonded to the cooling plate 206. Such bonding is achieved by example by brazing with molybdenum/ KOVAR^{®}. Other types of bonding or brazing materials are known to those skilled in the art. Alternately, the temperature control apparatus 202 of FIG. 5 is pressure fitted into the enclosure so as to be in intimate contact with the substrate support 105 and cooling plate 206.

A thermal-transfer fluid, such as water, helium or propylene glycol, flows from a thermal-transfer fluid source 220, through an inlet conduit 218 into inlet 210 of the cooling plate 206. The thermal-transfer fluid then flows through one or more coolant passages 208 and out of the cooling plate 206 through an outlet 212 and outlet conduit 222. The thermal-transfer fluid source 220 may also include a heat exchanger (not shown) wherein the thermal-transfer fluid is cooled or heated before being circulated into the cooling plate 206.

The array of TE devices 204 are disposed upon the cooling plate 206 for enhancing the conduction of heat from the E-chuck 105 to the thermal-transfer fluid or vice versa. When the TE devices are used to cool the electrostatic chuck 105, an electric current is provided to the TE devices 204 to create a cold side toward the electrostatic chuck 105 and a hot side toward the cooling plate 206. A cooled thermal-transfer fluid flows from the thermal-transfer fluid source 220 into the cooling plate 206 to cool the hot side of TE devices 204. As the hot side of the TE devices 204 is cooled by the thermal-transfer fluid, the cold side of the TE devices cools the E-chuck 105 proportionally. In this manner, the TE devices 204 enhances the conduction of heat from the electrostatic chuck 105, thereby increasing the efficiency of the cooling system.

When the TE devices are used to heat the electrostatic chuck 105, an electric current is provided to the TE devices 204 to create a hot side toward the electrostatic chuck 105 and a cold side toward the cooling plate 206. A heated thermal-transfer fluid flows from the thermal-transfer fluid source 220 into the cooling plate 206 to heat the cold side of TE devices 204. As the cold side of the TE devices 204 is heated by the thermal-transfer fluid, the hot side of the TE devices heats the electrostatic chuck 105 proportionally. Thus, the TE devices 204 enhance the responsiveness of the processing chamber 100 to changes in the temperatures in the electrostatic chuck 105 by actively pumping heat in the direction required.

with the configuration of the TE devices 204 and the processing (i.e., chucking and RF distribution) electrodes as described above, advantages are seen that improve overall upon the wafer fabrication process. The application described above for thermoelectric (TE) devices in processing systems provide an increased heat transfer rate at the source of the heat or at the location of the need for the heat, an increased heat transfer efficiency, an improved response time to temperature changes and a uniform heat transfer across the length of the cooled/heated object. Specifically, application and transmission of RF power is extremely efficient because of the proximity of the RF distribution electrodes 162 to the wafer 102. The necessary capacitive coupling of the RF power into materials other than the wafer 102 is kept to an absolute minimum. This condition results in more of such power being coupled into the wafer 102 and more uniformly distributed across the wafer surface as opposed to being dissipated in the form of heat or stray RF paths around the electrostatic chuck 105. The improved efficiency indicates that a smaller power can be applied for RF wafer biasing than is presently possible. For example, it is submitted that RF power source 124 can provide significantly less power than is presently necessary (on the order of 500W). Thus a per unit savings is realized by the reduced power consumption. Additionally, the RF power does not conduct through the TE devices 204 as they (and the plane they define) are below an RF "conduction plane" that is defined by the process electrodes 162. Since it is known and described here that the amount of heat transfer is controlled by the amount of current provided to the TE devices 204, any interference in the intended amount of current can deleteriously effect thermal transfer conditions. That is, RF power coupling through for example a cooling plate having TE devices thereupon can have a negative effect on the TE devices and possible render them damaged or useless. By disposing the TE devices below the RF conduction plane, both RF power transfer and thermal transfer integrity is maintained.

Preferably, one or more temperature sensors 224, such as thermocouples, are disposed adjacent the TE devices 204 to sense the temperature of the thermal-transfer fluid, the pedestal base 106 and/or the electrostatic chuck 105, thereby providing a real-time indication of the temperature at the source of the heat transfer. Alternatively, or additionally, one or more thermocouples are disposed on or adjacent the top surface of the electrostatic chuck 105 to provide a real-time indication of the temperature of the substrate 102. When an array of temperature sensors are disposed in a corresponding arrangement with an array of TE devices, each individual TE device can be adjusted to respond to changes in temperature as sensed by the individual temperature sensors near that particular the TE device. Thus, the TE devices provide individual control over different regions of the electrostatic chuck 105 to account for and reduce any temperature gradients across the electrostatic chuck 105. With the temperature sensors 224 and the TE devices 204 both located at the source of the heat transfer, the cooling system is able to respond very quickly to changes in the temperature of the electrostatic chuck 105 and can make immediate changes in the quantity or direction of the heat transfer. Therefore, the temperature of the pedestal assembly 104 can be very tightly controlled within a narrow temperature range.

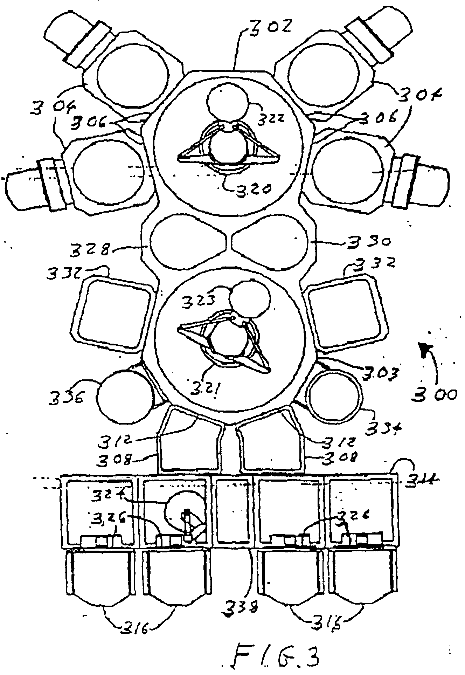

Figure 3 generally shows a schematic top view of an embodiment of a vacuum processing system 300. The system 300 shown in Figure 3 is an example of the Endura^{™} system available from Applied Materials, Inc., Santa Clara, California. Although the invention may be practiced with this system 300, it is understood that other types of vacuum processing systems may be used with the present invention, and the present invention is not limited to any particular type of vacuum processing system. The vacuum processing system 300 includes a transfer chamber 302 and a buffer chamber 303 typically mounted on a platform (not shown) generally forming a system monolith. The system monolith has two load lock chambers 308 mounted at facets 312. An optional mini-environment 314 may attach to the load lock chambers 308 for introducing substrates into the system 300. The transfer chamber 302 is shown with four process chambers 304 mounted at facets 306. The process chambers 304 perform the primary substrate process on the substrates in the vacuum processing system 300. Process chambers 304 may be any type of process chamber, such as a rapid thermal processing chamber, a physical vapor deposition chamber (PVD), a chemical vapor deposition chamber (CVD), an etch chamber, etc.

The process chambers 304 may be supported by the transfer chamber 302 or may be supported on their own platforms depending on the configuration of the individual process chambers 304. Slit valves (not shown) in the facets 306 provide access and isolation between the transfer chamber 302 and the process chambers 304. Correspondingly, the process chambers 304 have openings (not shown) on their surfaces that align with the slit valves.

A pre-clean chamber 328 and a cool-dcwn chamber 330 are disposed between the transfer chamber 302 and the buffer chamber 303. Alternatively, both of the chambers 328, 330 may be bi-directional to transfer substrates in either direction between the transfer chamber 302 and the buffer chamber 303, and one or more expansion chambers 332 may be a pre-clean chamber, if necessary. The pre-clean chamber 328 cleans the substrates before they enter the transfer chamber 302, and the cool-down chamber 330 cools the substrates after they have been processed in the process chambers 304. The pre-clean chamber 328 and the cool-down chamber 330 may also transition the substrates between the vacuum levels of the transfer chamber 302 and the buffer chamber 303. The buffer chamber 303 has two expansion chambers 332 for performing additional processes on the substrates. The buffer chamber 303 may further have an optional cool-down chamber 334 for further cooling the substrates if necessary. A location for an additional chamber 336, such as a substrate alignment chamber or an additional pre-processing (i.e., degassing) or post-processing chamber, is provided on the buffer chamber 303.

The load lock chambers 308 provide controlled transitions of the substrates between the ambient environment pressure to the chamber vacuum pressure. Openings (not shown) in facets 312 provide access and valves provide isolation between the load lock chambers 308 and the buffer chamber 303. Correspondingly, the load lock chambers 308 have openings on their surfaces that align with the openings in facets 312. The load lock chambers 308 and the optional mini-environment 314 have corresponding openings (not shown) providing access therebetween, while doors (not shown) for the openings provide isolation.

Prior to the introduction of 300-mm substrates in the semiconductor processing industry, cassettes of substrates were typically loaded by human operators directly into the load lock chambers 308. Thus, a mini-environment 314 was not present in the system 300. More recently, however, semiconductor fabrication facilities have been including a mini-environment 314 to enter the substrates into the processing system 300 using cassettes of substrates transported by a factory automation handling system to pod loaders 316 attached to a mini-environment 314. The present invention contemplates incorporation in both types of systems 300.

The mini-environment 314 has four pod loaders 316 attached on its front side 338 for receiving substrate cassettes from the factory automation. Openings (not shown) with corresponding doors 326 provide access and i isolation between the mini-environment 314 and the pod loaders 316. The pod loaders 316 are mounted on the side of the mini-environment 314 and are essentially shelves for supporting the substrate cassettes, or pods, (not shown) used to transport the substrates to and from the vacuum processing system 300.

A robot 320, or substrate handler, is disposed within the transfer chamber 302 for transferring a substrate 322 between the pre-clean chamber 328 and the cool-down chamber 330 and the process chambers 304. A similar robot 321 is disposed within the buffer chamber 303 for transferring a substrate 323 between the load lock chambers 308, the expansion chambers 332, the cool-down chamber 334, the additional chamber 336, the pre-clean chamber 328 and the cool-down chamber 330. Likewise, a robot 324 is disposed within the mini-environment 314 for transferring the substrates between the pod loaders 316 and the load lock chambers 308. The mini-environment robot 324 is typically mounted on a track so the robot 324 can move back and forth in the mini-environment 314, whereas the transfer and buffer chamber robots 320, 321 are mounted only for rotation.

The process chamber 304 includes an E-chuck having the TE devices and a cold trap gas exhaust according to the invention. Although the invention has been described above with reference to these embodiments, it is understood that the invention is not so limited, but may be used in any number of different applications within a processing system wherein a device, structure or surface needs to be cooled and/or heated to regulate the temperature of the device, structure or surface.

## Claims

1. An apparatus for controlling the temperature of a component of a processing system, comprising:
a pedestal base;
a substrate support disposed above the pedestal base thereby defining an enclosure;
a cooling plate disposed within said enclosure; and
a plurality of Peltier effect thermoelectric devices arranged on said cooling plate and in contact with said electrostatic chuck.

2. The apparatus of claim 1, wherein the substrate support is a monopolar electrostatic chuck.

3. The apparatus of claim 1, wherein the substrate support is a bipolar electrostatic chuck.

4. The apparatus of any preceding claim, wherein the substrate support includes an electrostatic chuck having a zoned chucking configuration.

5. The apparatus of any preceding claim, wherein the substrate chuck further comprises one or more heater electrodes.

6. The apparatus of any preceding claim, wherein the Peltier effect thermoelectric devices are arranged in a circular configuration on said cooling plate.

7. The apparatus of any preceding claim, wherein the Peltier effect thermoelectric devices are arranged in one or more concentric circles on said cooling plate.

8. The appartus of claim 7, wherein 40 Peltier effect thermoelectric devices ar aranged in two concentric circles on said cooling plate.

9. The apparatus of claim 8, wherein a first concentric circle defines an inner temperature control zone and a second concentric circle defines an outer temperature control zone.

10. The apparatus of any preceding claim, wherein the Peltier effect thermoelectric devices are in contact with said substrate support via a plurality of contacting means selected from the group consisting of adhesives, braze joints, biasing with spring-loaded members and integration during fabrication of the substrate support.

11. The apparatus of claim 10, wherein the contacting means of biasing with spring-loaded members further comprises a ring disposed within the enclosure, said ring having one or more springs provided therein.

12. The apparatus of claim 11, wherein the cooling plate is disposed on the ring.

13. The apparatus of claim 10, wherein the contacting means of biasing with spring-loaded member further comprises disposing the cooling plate on the spring loaded members thereby forcing the Peltier effect thermoelectric devices into intimate contact with the substrate support.

14. The apparatus of any preceding claim, further comprising an RF biasable electrode disposed in the substrate support.

15. The apparatus of claim 14, wherein the Peltier effect thermoelectric devices are disposed below said RF biasable electrode.

16. An apparatus for controlling the temperature of a component of a processing system, comprising:
a pedestal base;
a spring-biased ring disposed in said pedestal base;
a cooling plate disposed on said spring-biased ring;
a plurality of Peltier effect thermoelectric devices disposed upon said cooling plate; and
a puck disposed over said pedestal base and in contact with said Peltier effect thermoelectric devices.

17. The apparatus of claim 16, wherein the Peltier effect thermoelectric devices are arranged in a circular configuration on said cooling plate.

18. The apparatus of claim 16 or claim 17, wherein the Peltier effect thermoelectric devices are arranged in one or more concentric circles on said cooling plate.

19. The apparatus of any one of claims 16 to 18, wherein the puck is an electrostatic chuck.

20. The apparatus of claim 19, wherein the electrostatic chuck is RF biased.

21. An apparatus for controlling the temperature of a component of a processing system, comprising:
a pedestal base;
a cooling plate disposed above said pedestal base;
a lower support plate disposed above said cooling plate;
a plurality of Peltier effect thermoelectric devices disposed above said lower support plate;
an upper support plate disposed upon said plurality of Peltier effect thermoelectric devices; and
a puck disposed over said upper support plate.

22. The apparatus of claim 21, wherein the upper and lower support plates are aluminum.

23. The apparatus of claim 21 or claim 22, wherein said upper support plate is brazed to said puck.

24. The apparatus of any of claims 21 to 23, wherein said lower support plate is brazed to said cooling plate.
